# EUROPEAN PATENT APPLICATION

(11) **EP 4 443 174 A1**
(43) Date of publication of application: **09.10.2024**
(21) Application number: 24166167.7
(22) Date of filing: 26.03.2024
(51) Int. Cl.: G01R 15/20, G01R 33/00, H01L 23/31

(54) **CURRENT MEASUREMENT DEVICE, CORRESPONDING MANUFACTURING METHOD AND METHOD OF USE**

(30) Priority: 29.03.2023 IT 202300006099
(71) Applicant: STMicroelectronics International N.V., 1228 Plan-les-Ouates, Geneva (CH)
(72) Inventor: TIZIANI, Roberto, I-20014 Nerviano (Milano) (IT); DE VITI, Francesca, I-20133 Milano (IT)
(74) Representative: Buzzi, Notaro & Antonielli d'Oulx S.p.A.

(57) **Abstract**

An integrated circuit current sensing device (10), comprises an insulating encapsulation (20) that encapsulates a semiconductor die (14) having integrated therein a Hall current sensor (HS) configured to measure an electric current (I) flowing adjacent an active surface of the semiconductor die (14). Embedded in the insulating encapsulation (20) there is provided an electrically conductive trace (100) having opposed ends providing therebetween a current flow path adjacent the active surface of the semiconductor die (14).

First electrically conductive formations (101) extend through the insulating encapsulation (20) towards the opposed ends of the electrically conductive trace (100) embedded in the insulating encapsulation (20, 20', 20"). The first electrically conductive formations (101) are configured to cause (101) an electrical current subject to measurement to flow in the aforesaid current flow path adjacent the active surface of the semiconductor die (14). Second electrically conductive formations (182, 120, 121) extend through the insulating encapsulation (20) towards the active surface of the semiconductor die (14), the second electrically conductive formations (181, 182, 121) are configured to activate the Hall current sensor (HS) integrated in the semiconductor die (14).

## Description

### Technical field

The description relates to semiconductor devices.

Solutions as described herein can be applied to current sensor integrated circuit (IC) semiconductor devices based on Hall effect for application in automotive or industrial products, for instance.

### Background

A class of sensor for measuring electrical currents is based on the well-known Hall effect.

For low current applications, for instance, up to 50 A, Hall sensors are conventionally assembled in a package that is mounted (via surface mounting technology, SMT, for instance) on a substrate such as a printed circuit board, PCB, comprising an electrically conductive strip or trace that provides a current flow path for the current to be measured flows running below, that is, externally of, the package.

The magnetic field generated by the strip is measured by the sensor that is arranged in proximity of the electrically conductive strip.

Such devices suffer from a relatively low sensitivity and the measure may be affected by noise. This results in poor accuracy of the sensor.

In order to increase the accuracy of a current sensor, leadframe-based packages can be used where a leadframe is designed in order to re-direct the current to be measured from the PCB via the leadframe leads and cause it to flow just below the IC sensor.

Such devices involve complex assembly techniques and the active portion of the sensor is still relatively far from the conductive strip or trace where the current flows, so that sensor accuracy is hardly improved.

By way of background, documents such as:
US 11422164 B2, or
US 6812687 B1,
are exemplary of various advances in providing current measuring devices with improved accuracy.

### Object and summary

Solutions as described herein aim at addressing the issues discussed in the foregoing.

Such an object can be achieved via a device having the features set forth in the claims that follow.

One or more embodiments relate to a corresponding method of manufacturing.

One or more embodiments relate to a corresponding method of use.

The claims are an integral part of the technical teaching provided in respect of the embodiments.

Solutions as described herein propose a simple, flexible and cost-effective method of manufacturing current sensor semiconductor devices based on the Hall effect with improved accuracy and sensitiveness.

In solutions as described herein, a manufacturing process may be carried out at wafer or panel level in order to facilitate concurrent processing of a plurality of devices.

In solutions as described herein, a conductive trace configured to carry the current to be measured is embedded in the package and runs close to the sensor die.

In solutions as described herein, the shape of a conductive trace may be designed to increase/decrease the intensity of the magnetic field generated by the current and measured by the Hall sensor.

### Brief description of the several views of the drawings

One or more embodiments will now be described, by way of example only, with reference to the annexed figures, wherein:
Figures 1A to 1K are exemplary of a possible sequence of steps in implementing embodiments of the present description, and
Figures 2 to 5 are plan views of the structure of semiconductor devices according to embodiments of the present description, exemplary of the results of various steps in the sequence of Figures 1A to 1K.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

A class of integrated circuit (IC) sensors for measuring current flow are based on the Hall effect. As known to those skilled in the art, these sensors are based on the principle of measuring the voltage induced (in an electrically conductive portion of the sensor) in response to a magnetic field generated by the current to be measured.

Conventional Hall sensors are mounted (for instance, via surface mounting technology, SMT) on a substrate, such as a printed circuit board (PCB), above a conductive trace or strip carrying the current to be measured.

In such a package design, the conductive strip/trace lies externally of the sensor package, relatively far from the sensor.

Such a conventional approach is found to have low accuracy and with the measurement strongly affected by noise. In fact, a substrate such as a PCB, may host a high number of traces carrying currents that may adversely affect the measuring process.

In order to improve the accuracy of such Hall sensors, leadframe-based packages can be resorted to where the current to be measured is redirected from the PCB strip into the package.

Such conventional leadframe-based packages may give rise to various issues.

For instance:
every device design may involve a corresponding leadframe design,
the assembly process may involve steps, for instance, wire bonding, that may be unduly complex, and
processing such as wire bonding may reduce electrical performance (with high electrical losses, for instance) of the device.

Moreover, in such conventional devices, the conductor carrying the current to be measured is still relatively far from the sensor, which has a negative impact on accuracy.

Solutions as described herein propose a simple, flexible and cost-effective method of manufacturing current sensor (integrated circuit, IC) semiconductor devices with improved accuracy.

In solutions as described herein, a conductive trace configured to carry the current to be measured is embedded in the package and runs close to the sensor die.

In solutions as described herein, the shape of a conductive trace may be designed to increase/decrease the intensity of the magnetic field generated by the current and measured by the Hall sensor.

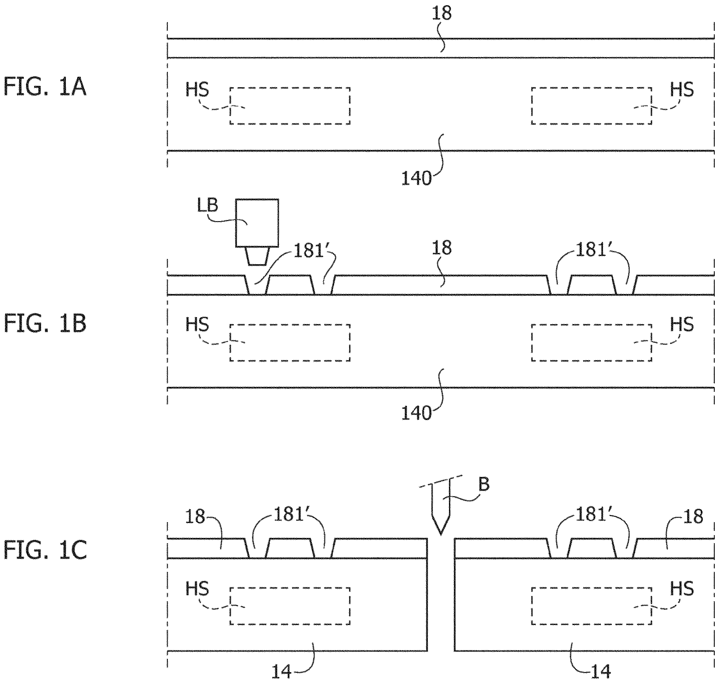

Figures 1A to 1K illustrate a sequence of steps of a method of manufacturing current sensor (integrated circuit) semiconductor devices based on the Hall effect.

It is noted that the sequence of steps of Figures 1A to 1K is merely exemplary insofar as:
one or more steps illustrated in Figures 1A to 1K can be omitted, performed in a different manner (with other tools, for instance) and/or replaced by other steps;
additional steps may be added;
one or more steps can be carried out in a sequence different from the sequence illustrated.

Figures 1A to 1C are illustrative of processing steps that may be performed at wafer level, thus facilitating concurrent processing of a plurality of semiconductor devices.

Figure 1A is illustrative of a semiconductor (for instance, silicon) wafer 140 being provided with an insulating film 18 laminated on the active surface thereof.

The semiconductor wafer 140 includes integrated circuits, ICs, Hall sensors HS chips or dice already formed therein in any manner known in the art.

As used throughout this description, the terms chip/s and die/dice are regarded as synonymous.

The insulating film 18 may be, for instance, an Ajinomoto Build-up Film (ABF) available from Ajinomoto Fine-Techno Co., Inc. of 1-2 Suzuki-cho, Kawasaki-ku, Kawasaki-shi, 210-0801, Japan.

The film 18 can be laminated on a first (active) surface of the wafer 14 and may vary in thickness according to the design of the device; for instance, as it will be discussed in the following, the thickness of the film 18 may be useful in controlling the distance between the Hall sensor HS (formed in the wafer 140) and the conductive trace carrying the current to be measured.

Figure 1B is illustrative of vias 181' opened (for instance, via laser beam LB) to the die pads (not visible in the figures for scale reasons) on the active surface of the dice/chips comprised in the wafer 140.

As illustrated in Figure 1C, the semiconductor wafer 140 can thus be cut (or "singulated") into individual dice or chips 14 having formed therein an IC Hall sensor HS. As illustrated, singulation may be performed via a blade or a saw B, for instance.

Prior to singulation, a grinding step may be performed in order to reduce in as much as possible the thickness of the semiconductor wafer 140. This step is not visible in the figure for simplicity.

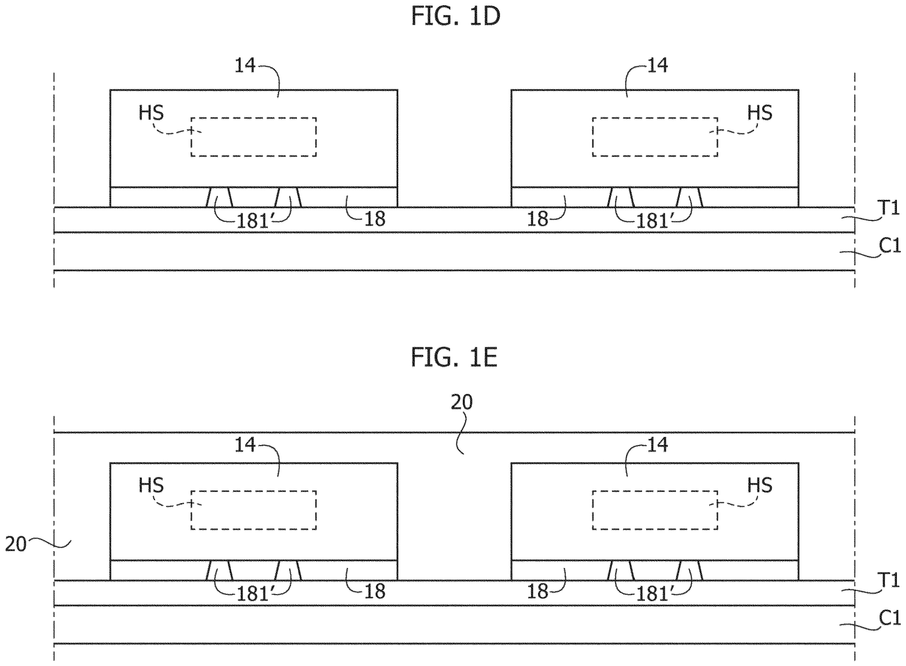

As illustrated in Figure 1D, singulated dice/chips 14 may be arranged on a carrier (a tape, for instance) C1 for further processing, possibly with a release tape T1 laminated on the carrier C1 in order to facilitate releasing of the device from the carrier C1 after processing.

Concurrently processing of a plurality of semiconductor devices is facilitated by arranging them on such a carrier C1.

Processing using a wafer-shaped carrier or a panel-shaped is oftentimes referred to as wafer/panel level packaging, the main difference being the shape of the carrier. The processing steps described in the following may be performed (in a manner known per se to those skilled in the art) irrespective of the shape of the carrier C1 and thus apply to both wafer and panel level packaging.

Figure 1D is illustrative of the fact that dice 14 can be:
"flipped" (that is, turned over) so that their active surface with the film 18 laminated thereon faces the tape T1 and the carrier C1, and
arranged on the carrier C1 with some spacing between them.

Figure 1E is illustrative of a first molding step where an electrically insulating molding compound 20 such as an epoxy resin, for instance, is molded onto the dice 14 arranged on the tape T1 in order to form a first portion of encapsulation that protects and insulates the dice 14.

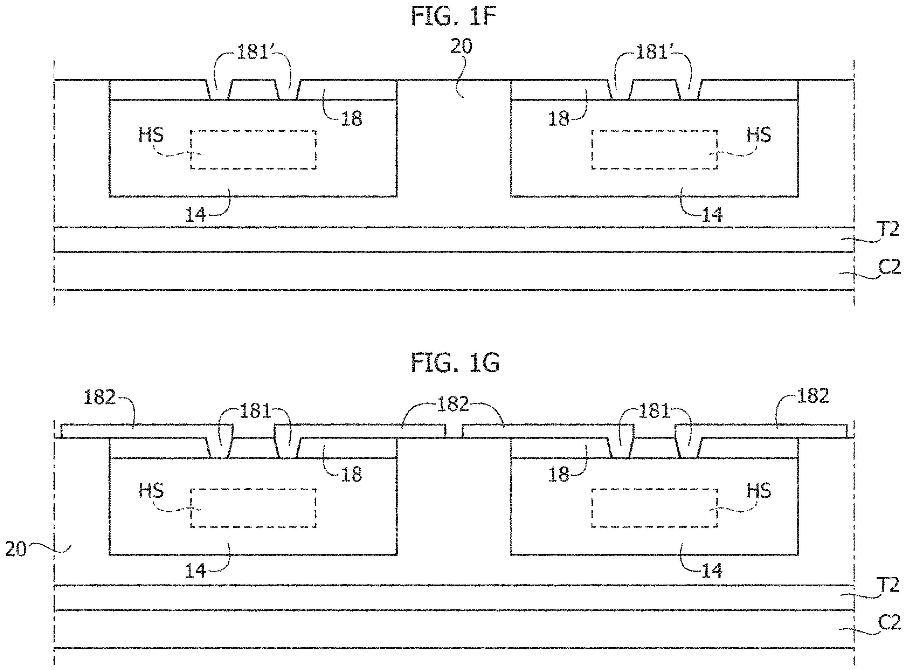

As illustrated in Figure 1E, and 1F, the dice 14 with the molding compound molded 20 on their back or bottom surface are detached from the (first) carrier C1 (this is facilitated by the release tape T) and arranged on a second carrier C2 with their active surface facing up, as illustrated in Figure 1F, in order to facilitate further processing. The second carrier C2 may also have a release tape T2 laminated thereon.

Using different designations of the carriers C1, C2 and the release tapes T1, T2 is primarily for ease of explanation: in fact, a same (type of) carrier and tape can be used in both instances.

Figure 1G is illustrative of metallic material (such as copper, for instance) grown/deposited on the active surface of the dice 14.

Vias 181 and traces 182 are formed on the active surface of the die 14 in order to provide input/output electrical coupling to the die.

As illustrated in Figure 1G, the vias 181 are filled with electrically conductive material (for that reason they are no longer referenced with the references 181' introduced in connection with Figure 1B) and provide electrical coupling between the die pads on the active surface of the die 14 (not visible in the figures for scale reasons) and traces 182 at the active (here, front or top) surface of the assembly.

Growing metallic material as illustrated in Figure 1G may be performed in any manner known in the art.

For example, a photolithographic process, per se known in the art, may be used to grow vias 181 and traces 182 as illustrated.

Such a photolithographic process may involve:
depositing, for instance, via sputtering, a seed layer (comprising, for instance a Ti layer followed by a Cu layer) in order to facilitate subsequent electroplating/galvanic growth of metallic material (such as copper),
providing photoresist material on the seed layer, such as a dry photoresist film laminated on the seed layer deposited previously,
exposing the dry film to (for instance, UV) light, via laser direct imaging, LDI, for instance, and developing the dry film to transfer a desired pattern to the photoresist film,
growing metallic material with the desired pattern via an electroplating/galvanic deposition process thus forming electrically conductive vias 181 and traces 182, and
stripping the dry film and etching away the seed layer (where it is not covered with the metallic materials of the vias 181 and traces 182) thus obtaining the assembly illustrated in Figure 1G.

Such a photolithographic process is per se conventional in the art, which makes it unnecessary to provide a more detailed description.

A different technique may be used to deposit metallic material to form vias 181 and traces 182. For example, laser induced forward transfer, LIFT, may be used to form vias 181 and traces 182.

LIFT denotes a deposition process where material from a donor tape or sheet is transferred to an acceptor substrate facilitated by laser pulses.

General information on the LIFT process can be found, for instance, in P. Serra, et al.: "Laser-Induced Forward Transfer: Fundamentals and Applications", in Advanced Materials Technologies/Volume 4, Issue 1.

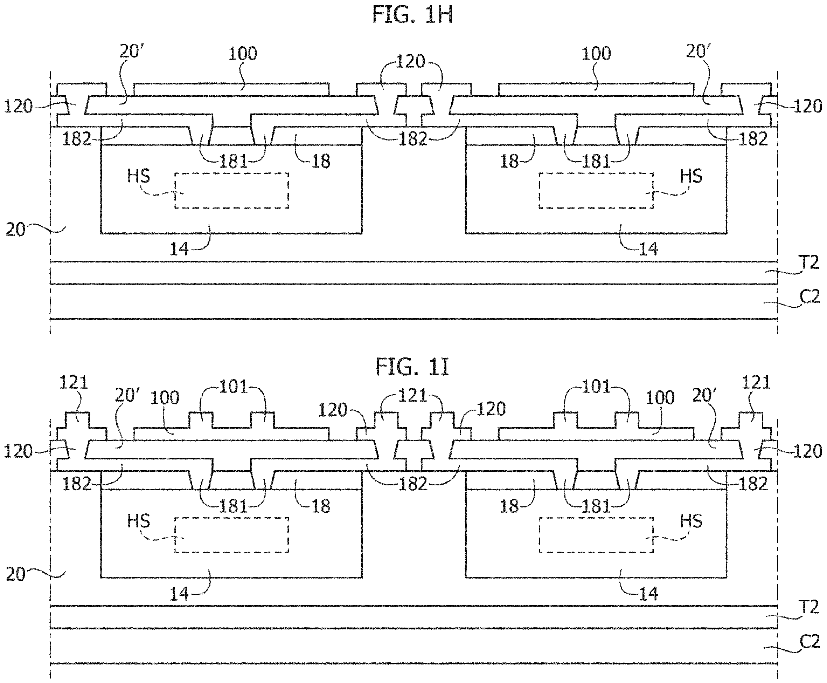

Figure 1H is illustrative of an additional layer of metallic material (such as copper, for instance) deposited on the assembly of Figure 1G to form input/output (I/O) pads 120 and a (main) trace 100.

Providing pads 120 and trace 100 as illustrated in Figure 1H may involve the following steps:
a molding step, wherein additional molding compound 20' is molded onto the assembly illustrated in Figure 1G,
providing (through-mold)vias to the traces 182 formed previously, and
growth/deposition of metallic material (copper, for instance) to form pads 120 and the main trace 100, in any manner known in the art (for instance, photolithography or LIFT as discussed previously).

The main trace 100 is the electrically conductive formation that carries the electrical current to be measured by the IC Hall sensor HS. As it will be discussed in the following, the shape of the main trace 100 may play a role in determining the magnitude/intensity of the magnetic field generated by the current flowing in the main trace 100.

Whatever the particular shape, the main trace 100 can be formed with a deposition/growth as described previously, for example by changing the pattern transferred to the photoresist film, in the exemplary case wherein photolithography is used to grow the main trace 100.

Figure 1I is illustrative of a deposition step to form studs 121 for the I/O pads 120 and studs 101 for the main trace 100. Again, the deposition/growth step may be performed via any technique known in the art, such as photolithography or LIFT, for instance.

The schematic representation of Figure 1I, and in particular, the shape of the main trace 100 as well as the position of the main trace studs 101, must not be construed in a limiting sense; the shape of the main trace will be described in more detail in the following, when describing devices according to embodiments of the present description that may be obtained with the method described herein.

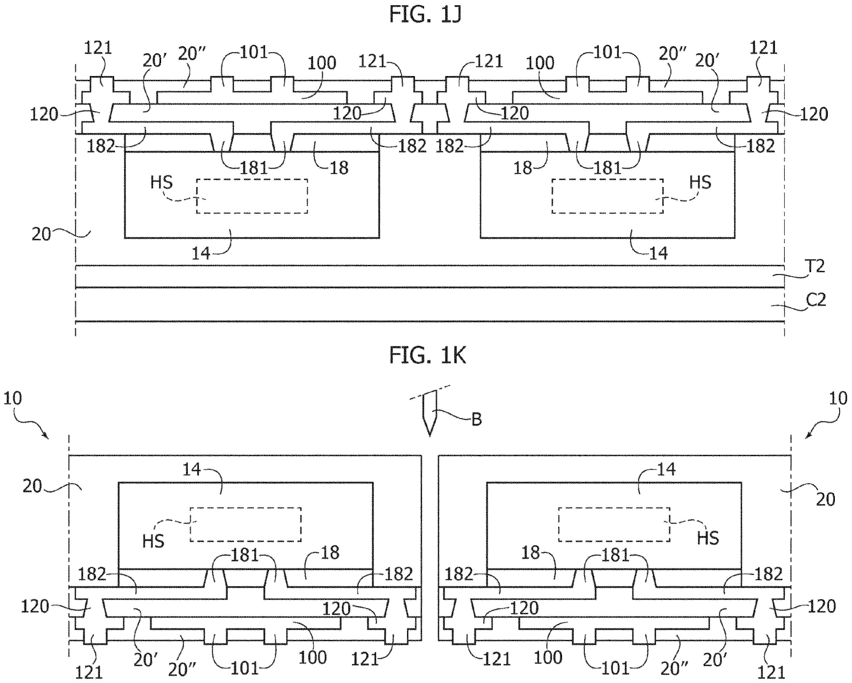

Figure 1J is illustrative of a further molding step wherein a molding compound 20" (for instance, an epoxy resin) is molded onto the assembly illustrated in Figure 1I, thus completing the protective plastic package (encapsulation) of the devices.

As described herein, the plastic package (that is, the encapsulation) is formed in three molding steps, namely the molding steps illustrated in Figures 1E, 1H and 1J leading to three encapsulation masses/layers 20, 20', and 20" being molded. However, a different sequence of steps may be envisaged in order to provide such a protective plastic package to the device.

It is otherwise noted that the traces 182 can be possibly realized (in a manner known to those of skill in the art) to provide a multi-layered redistribution layer.

A plastic package as illustrated herein, however provided, has the main trace 100 completely embedded therein. That is, the main trace 100 carrying the current to be measured is internally of the package of the device.

Figure 1K is illustrative of a final singulation step wherein the panel (or wafer) is singulated into final individual devices 10.

The singulation step may be performed via cutting or sawing with a blade B after releasing the panel/wafer from the carrier C (facilitated by the release tape T).

Optional processing steps, possibly performed prior to the final singulation step illustrated in Figure 1K, may include:
a grinding step to form a more even surface of the device,
a plating step to form a solderable, electrically conductive layer on the external surface of the studs 101, 121, and
a laser marking step, for identification of the device.

The sequence of Figures 1A to 1K and the related discussion give a description of an exemplary manufacturing method of a Hall current sensor (IC) semiconductor device.

As described herein, such a method involves encapsulating (for instance, via several molding step) in an insulating encapsulation 20, 20', 20" a semiconductor die 14.

The semiconductor die 14 has integrated therein a Hall current sensor HS configured to measure an electric current I flowing adjacent the active surface of the semiconductor die 14.

An electrically conductive (main) trace 100 is formed embedded in the insulating encapsulation 20, 20', 20". The electrically conductive trace 100 has opposed ends that provide therebetween a current flow path adjacent the active surface of the semiconductor die 14.

First (studs 101) and second (vias 181, traces 182 and external pads 120, 121) electrically conductive formations are provided (via photolithography or LIFT, for instance) through the insulating encapsulation 20, 20', 20".

The first electrically conductive formations 101 are coupled to the opposed ends of the electrically conductive trace 100 and are configured to cause an electrical current subject to measurement to flow the current flow path adjacent the active surface of the semiconductor die 14.

The second electrically conductive formations 181, 182, 120, 121 are directed towards the active surface of the semiconductor die 14 and are configured to activate (transferring I/O signals and powering, for instance) the Hall current sensor HS integrated in the semiconductor die 14.

Advantageously, an insulating film 18, such as an Ajinomoto Build-up Film, for instance, may be laminated on the active surface of the semiconductor die 14.

In this case, vias 181' are opened (via laser beam LB) through the insulating film 18 and (a portion of) the second electrically conductive formations 181 towards the active surface of the semiconductor die 14 comprise electrically conductive material at the vias 181' opened through the insulating film 18.

As mentioned, the sequence of steps of Figures 1A to 1K is merely exemplary insofar as one or more steps illustrated in the figures can be omitted, performed in a different manner, additional steps may be added and one or more steps can be carried out in a sequence different from the sequence illustrated.

It will be appreciated that the assembly flow described so far may be carried out at wafer or panel level (that is, irrespective of the shape of the carrier) facilitating concurrent processing of a (large) number of devices 10, thus providing a time- and cost-effective manufacturing method.

Moreover, the assembly flow described herein does not involve providing a substrate (an electrically conductive substrate such as a leadframe, for instance) to be designed with regard to the particular device design, thus further reducing design and manufacturing costs.

Furthermore, electrical coupling is provided via direct interconnects (that is, vias 181, 120 traces 100, 182 and studs 101, 121), oftentimes referred to as direct copper interconnects (DCI), due to the extensive - but still, not mandatory - use of copper to form such interconnects with no use of (electrically conductive) wires that can reduce electrical performance and make the assembly flow more complex (involving, for example, a wire-bonding formation step).

Devices 10 as illustrated in Figure 1K are intended to be mounted (for instance, soldered) on a final substrate such as a printed circuit board, PCB.

Pads 121, 120 (and respective electrical formations 182, 181) may be used to power the device 10 and to provide I/O signals thereto.

Studs 101 provide an electrical coupling between the trace/strip in the PCB carrying the current to be measured and the main trace 100 inside the package of the device 10.

The current flowing in the main trace 100 generates a magnetic field which is measured by the sensor die 14. Such a sensor die 14 has an active portion configured to measure the magnetic field by measuring a voltage induced therein via Hall effect. Such an IC sensor die 14 is per se conventional in the art making it unnecessary to provide a more detailed description herein.

The intensity of the magnetic field at the active portion of the sensor die 14 may depend, aside from the intensity of the current generating the field, on the shape of the main trace 100 carrying the current, on the distance between the main trace 100 and the active portion of the sensor die 14 and on the magnetic properties of the material(s) therebetween.

The distance between the main trace 100 and the active portion of the IC Hall sensor die 14 can be controlled, for example, by varying the thickness of the film 18; in fact, insulating films (such as the ABF already mentioned) having different thicknesses are commercially available.

The thickness of the molding compound 20 layer between the main trace 100 and the insulating film 18 (formed in the assembly step illustrated in Figure 1H) may also be varied (within certain limits, at least) in order to fine-tune the intensity of the magnetic field at the active portion of the sensor die 14.

Varying (for a same current intensity) the intensity of the magnetic field at the active portions of the sensor die 14 (by "tuning" the features listed in the foregoing) may advantageously improve performance and flexibility of the device 10.

For example, the intensity of the magnetic field may be increased/maximised by reducing the distance between the main trace 100 and the sensor die 14, in order to increase the signal-to-noise ratio thus improving the accuracy of the measuring device 10.

In fact, as mentioned, an actual PCB may be "overcrowded" with several current-carrying lines/traces running also in the vicinity of the sensor device, which may negatively affect measuring accuracy; by increasing the magnetic field at the active portion of the sensor die 14, the signal-to-noise ratio is increased and the measuring accuracy improved.

On the other hand, one may also be interested in reducing the intensity of the magnetic field at the sensor die 14 by increasing the distance between the main trace 100 and the sensor die 14. For example, when currents of relatively high intensity are desired to be measured, a reduction of the magnetic field at the sensor die 14 facilitates using a sensor die 14 configured for smaller currents, that is a smaller scale measuring device.

As mentioned, the shape of the main trace 100 may also play a role in determining the intensity of the magnetic field at the (active portion of) the sensor die 14.

In the following, devices with differently shaped main traces 100 will be described.

As those skilled in the art may appreciate, the various embodiments presented in the following may be obtained via the same processing steps described in relation to the sequence of Figures 1A to 1K.

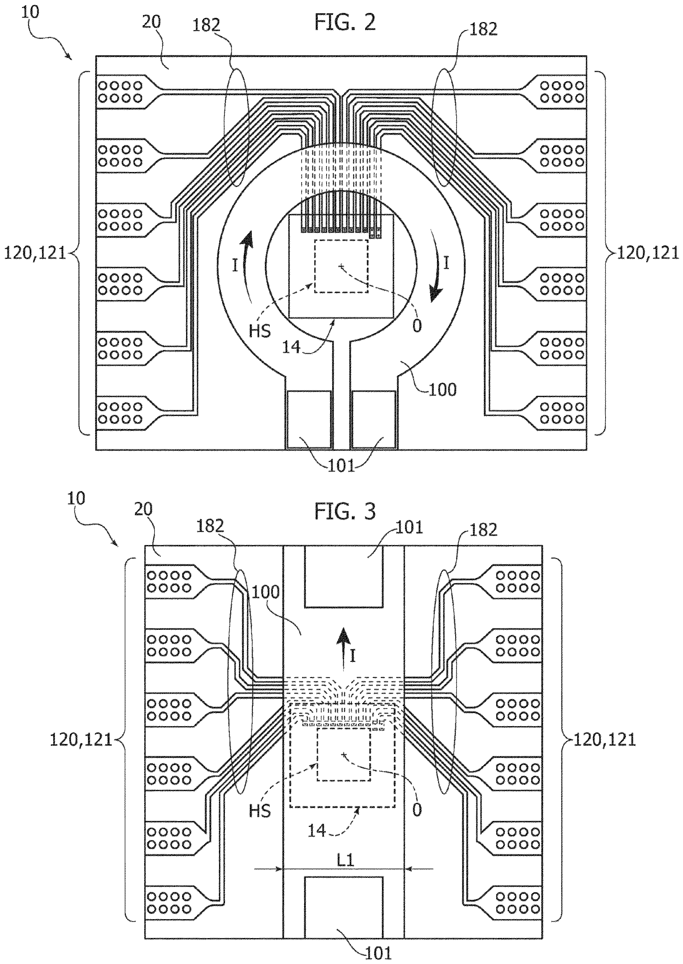

For instance, the differently shaped main traces 100 illustrated in Figures 2 to 4 may be formed with a similar growth/deposition process (for instance, photolithography or LIFT) as discussed in the foregoing and schematically illustrated in Figure 1K.

Figure 2 is a plan view illustrative of the bottom of a device 10 that can be obtained according to embodiments of the present description.

As used herein, the term "bottom" refers to the side of the device 10 having the studs 101, 121 protruding therefrom, or, said otherwise, the side of the device facing the final substrate (for instance, a PCB) when mounted (for instance, soldered) thereon.

In Figure 2 (and in Figures 3, 4 and 5 that follow) the outmost molding compound layers 20', and 20" are not represented in order to clearly illustrate the details of the structure of the device 10. Only the "background" layer 20 (formed, for instance, in the processing step illustrated in Figure 1E) is illustrated in these figures.

External pads 120, 121 for I/O signals or powering of the device 10 are arranged at the periphery of the device 10 and are electrically coupled to the sensor die 14 via electrically conductive traces 182.

The electrically conductive traces 182 thus couple the external pads 120, 121 to the die pads provided on the active surface of the die 14 via vias 181 opened (and filled with metallic material, such as copper, for instance) in the insulating film 18 laminated on the active surface of the die 14. Vias 181 and die pads are not visible in Figure 2 for scale reason.

The number of external pads 120, 121, their position as well as the pattern of traces 182 illustrated in Figure 2 (and in Figures 3, 4 and 5) is merely exemplary and shall not be construed in a limiting sense; a different number and/or a different arrangement of the external pads 120, 121 may be envisaged according to the particular design of the device 10. Correspondingly, electrically conductive traces 182 may be provided with a different pattern.

As illustrated in Figure 2 a device 10 may be provided with a loop-shaped main trace 100 configured to carry the current to be measured.

Studs 101 are provided in order to electrically couple a conductive strip or trace provided on the final substrate (for instance, a PCB) the device 10 is intended to be mounted on, to the main traces 100 of the device 10 embedded in the molding compound 20 of the encapsulation.

The strip or trace on the substrate carries the current to be measured.

The current is then redirected into the main trace 100 of the device 10 (via the studs 101 illustrated on the left, for instance).

The current thus flows in the main trace 100 of the device 10. A current flow is represented by the arrows in Figure 2 and referenced therein with the reference I.

The current is finally "returned" to the trace or strip in the substrate (for instance, a PCB) via a stud 101 (for instance, the stud 101 on the right).

As illustrated, the sensor die 14 may be arranged at the center of the loop shaped main trace 100 in a plane parallel to the one of the main trace 100 and at a distance therefrom.

As mentioned, the distance between the two planes, namely the planes of the sensor die 14 and the plane of the main trace 100, may be varied by varying the thickness of the insulating film 18 (for instance, an Ajinomoto Build-up Film) and of the molding compound layer therebetween, as discussed previously.

The current I flowing in the main trace 100 generates a magnetic field having an intensity (at the active portion of the sensor die 14) which is measured (via the induced Hall voltage, for instance) by the sensor die 14. In the following it will be assumed that the intensity of the magnetic field at the point O of the sensor die 14 is the relevant quantity measured by the sensor die 14. As exemplified in the figures, point O is located in the center of the sensor die 14 but the exact location will depend on the actual design of the sensor die 14, the details of which are not of interest herein, and point O will be assumed to be comprised in the active portion of the sensor die 14.

As discussed, the intensity of the magnetic field at point O of the sensor die 14 may depend on:
the intensity of the current I to be measured,
the distance between the sensor die 14 and the main trace 100,
the magnetic properties of the materials between the sensor die 14 and the main trace 100, and
the geometry of the main trace 100, a loop-shaped main trace 100 in the embodiment exemplified in Figure 2.

Thickness and/or width of the main trace 100 illustrated in Figure 2 may be also varied in order to vary the intensity of the magnetic field at point O.

It is noted that by varying the thickness and the width of the main trace 100 (that is, by varying the area of its cross-section) also the electrical resistance of the main trace 100 changes.

As known to those skilled in the art, the magnetic field generated at point O by a current I flowing in the loop-shaped main trace 100 illustrated in Figure 2 will be directed (mainly) in the direction perpendicular to the plane of the main trace 100.

Figure 3 is illustrative of possible embodiments of the present description, wherein the current sensor device 10 is provided with a slab-shaped main trace 100.

Once more, for the sake of simplicity and ease of understanding, unless the context indicates otherwise, parts or elements like parts or elements already discussed in connection with Figure 2 are indicated in Figures 3 to 5 with like reference symbols, and a detailed description will not be repeated for brevity.

Studs 101 are provided to electrically couple the strip/trace on the substrate to the slab-shaped main trace 100 of the device 100 and are advantageously formed at the two opposed sides thereof.

The slab-shaped main trace 100 illustrated in Figure 3 is formed in a plane parallel to the plane of the sensor die 14, at a distance therefrom. It is noted that in this embodiment the main trace 100 "covers" the sensor die 14 which is correspondingly illustrated in dashed line in the figure.

As illustrated, the slab-shaped main trace 100 is provided with a transverse width L1 (in the direction of the plane of the sensor die 14) which determines, keeping all other factors constant, the intensity of the magnetic field generated by the current I at point O of the sensor die 14.

As illustrated in Figure 3, the width of the main trace 100 may be constant along its length. However, a main trace 100 with a varying width may be envisaged.

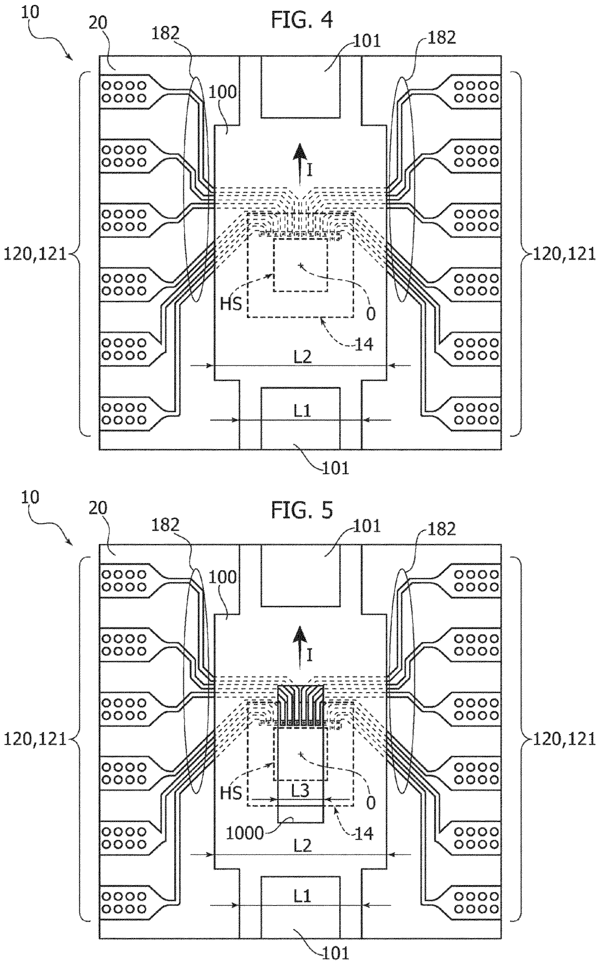

As illustrated in Figure 4, the main trace 100 may have an extremal widths L1 (at the studs 101) different from - for instance, narrower than - the width L2 of an intermediate portion therebetween.

Furthermore, a main trace 100 with a stepped profile as illustrated in Figure 4 may be replaced by a main trace 100 provided with a balloon-like profile displaying a smoother transition between the extremal width (for instance, having a minimum width L1) and the central width (for instance, characterized by a maximum width L2).

The magnetic field generated at point O by a current I flowing in a main trace 100 as illustrated in Figure 3 will be mainly directed in a direction parallel to the main trace 100 and transverse to the current I flow, and its intensity will depend also on the particular geometry of the slab-shaped main trace 100, namely on the parameters L1, L2 for instance.

It is noted that the (varying) widths L1, L2 of the slab-shaped main trace 100 also affect the overall resistance of the main trace 100.

Figure 5 is exemplary of embodiments of the present description wherein a trace 100 (similar to the one illustrated in Figure 4) is provided with an aperture or slit 1000 in a portion of its length.

The aperture 1000 has a width L3 the value of which affects the magnetic field generated at point O by a current I flowing through the main trace 100.

The various embodiments illustrated in Figures 2 to 5 may be (easily) obtained (with minor modifications) via the same method described in relation to the Figures 1A to 1K.

Notionally, only the steps where the main trace 100 and the studs 101 are formed (that is, the steps illustrated in Figures 1E and 1F) can be modified in order to obtain the different main trace 100 designs illustrated in Figures 2 to 5.

Given a current intensity range to be measured (that is, a working range for the device 10) it is possible to vary the intensity of the magnetic field at the active portions of the sensor die 14 (assumed to comprise point O illustrated in Figures 2 to 5) by varying the shape of the main trace 100 the device 10 is provided with.

Table I below summarizes calculated magnetic field intensities H-y [kA/m] at point O for various configurations (L3 vs. L2) of the main trace 100.

Table II below summarizes by way of reference calculated resistance values [mOhm - DC] for corresponding configurations (L3 vs. L2) of the main trace 100.

**Table I - calculated intensities H-y [kA/m] at point O**

| L3 ∨ | L2 > | 1.2 mm | 1.5 mm | 2.00 mm |
|---|---|---|---|---|
| 0 mm | | 13.5 | - | - |
| 0.1 mm | | 12.3 | 8.9 | 6.7 |
| 0.2 mm | | 10.1 | 7.5 | 4.8 |
| 0.3 mm | | 7.2 | 5.3 | 3.4 |
| 0.4 mm | | 5.5 | 4.6 | 3.6 |
| 0.5 mm | | 4.5 | 3.7 | 2.9 |

**Table II - resistance [mOhm - DC]**

| L3 | L2 | 1.2 mm | 1.5 mm | 2.00 |
|---|---|---|---|---|
| ∨ | > | | | mm |
| 0 mm | | 0.9 | - | - |
| 0.1 mm | | 0.92 | 0.78 | 0.67 |
| 0.2 mm | | 0.96 | 0.81 | 0.69 |
| 0.3 mm | | 1.01 | 0.84 | 0.71 |
| 0.4 mm | | 1.07 | 0.87 | 0.73 |
| 0.5 mm | | 1.15 | 0.92 | 0.75 |

The results relate to a slab-shaped main trace 100 as illustrated in Figure 5 characterized by an extremal width L1 having a fixed value, namely L1=1.2 mm, a central portion characterized by a width L2 (varying along the columns of the table) and an aperture 1000 of width L3 (varying along the rows of the table, wherein L3=0 means no aperture).

A DC current flowing through the main trace is assumed to be 50 (A) and a step profile of the main trace 100 as illustrated in Figures 4 and 5 is assumed.

The reported values of the intensity of the magnetic field at point O are expressed in kA/m and refer to the component of the magnetic field parallel to the plane of the main trace 100 and perpendicular to the direction of the current flow.

As reported in Table I, the value of the magnetic field may be efficiently varied by differently shaping the main traces 100.

The max value (13.5 kA/m) is obtained for slab-shaped main trace 100 having a constant width (L1=L2) with no apertures (L3=0) provided, while the minimum value (2.9 kA/m) is obtained with the largest values of central and aperture width, L2=2.0 mm and L3=0.5 mm and a difference of (almost) an order of magnitude is obtained.

The values and widths indicated in Table I and Table II are merely exemplary and shall not be construed in a limiting sense: they are reported herein only for exemplary purposes.

In certain cases, for example for low current applications, it may be desirable to increase in as much as possible the intensity of the magnetic field generated by the current to be measured, in order to reduce the signal to noise ratio and thus improving the accuracy of the measuring device 10.

In fact, as mentioned, the final substrate (for instance, a PCB) comprising the trace/strip carrying the current to be measured, may be comprise several current carrying lines/traces, which may negatively affect measuring accuracy.

In such a case it may be desirable to provide the device 10 with a main trace 100 maximising the magnetic field generated by the current, by forming a loop-shaped (Figure 2) or a slab-shaped with no aperture (Figure 3) main trace 100, for instance.

Reducing the intensity of the magnetic field at the sensor die 14 may be desirable, in the case of high intensity current, for instance. In such cases, a reduction of the magnetic field at the sensor die 14 facilitates using a sensor die 14 configured for measuring lower intensity magnetic fields.

To sum up the main trace 100 configured to carry the current I to be measured, may be provided with various shapes.

Advantageous choices include:
a loop-shaped main trace 100,
a slab-shaped main trace 100 with constant (for instance, L1=L2) or varying (L1≠L2) width, and
a slab-shaped main trace 100 provided with an aperture 1000.

Without prejudice to the underlying principles, the details and embodiments may vary, even significantly, with respect to what has been described by way of example only without departing from the extent of protection.

The extent of protection is determined by the annexed claims.

## Claims

1. A device (10), comprising:
an insulating encapsulation (20, 20', 20") encapsulating a semiconductor die (14), wherein the semiconductor die (14) has integrated therein a Hall current sensor (HS) configured to measure an electric current (I) flowing adjacent an active surface of the semiconductor die (14),
an electrically conductive trace (100) embedded in the insulating encapsulation (20, 20', 20") the electrically conductive trace (100) having opposed ends providing therebetween a current flow path adjacent the active surface of the semiconductor die (14),
first electrically conductive formations (101) through the insulating encapsulation (20, 20', 20") towards the opposed ends of the electrically conductive trace (100) embedded in the insulating encapsulation (20, 20', 20"), the first electrically conductive formations (101) configured to cause (101) an electrical current subject to measurement to flow in said current flow path adjacent the active surface of the semiconductor die (14), and
second electrically conductive formations (181, 182, 120, 121) through the insulating encapsulation (20, 20', 20") towards the active surface of the semiconductor die (14), the second electrically conductive formations (181, 182, 120, 121) configured to activate the Hall current sensor (HS) integrated in the semiconductor die (14) .

2. The device (10) of claim 1 comprising an insulating film (18), preferably an Ajinomoto-Build-Up-Film, laminated on the active surface of the semiconductor die (14), wherein the second electrically conductive formations (181, 182, 120, 121) comprise electrically conductive material at vias (181') opened through the insulating film (18).

3. The device (10) of claim 1 or claim 2 wherein the electrically conductive trace (100) embedded in the insulating encapsulation (20, 20', 20") has a loop shape.

4. The device (10) of claim 1 or claim 2 wherein the electrically conductive trace (100) embedded in the insulating encapsulation (20, 20', 20") has a slab shape.

5. The device (10) of any of the previous claims, wherein the electrically conductive trace (100) embedded in the insulating encapsulation (20, 20', 20") has an intermediate portion between said opposed ends, wherein:
the intermediate portion is wider (L2) than the opposed ends, and/or
an aperture (1000) is provided in said intermediate portion.

6. A method, comprising:
encapsulating in an insulating encapsulation (20, 20', 20") a semiconductor die (14) having an active surface, wherein the semiconductor die (14) has integrated therein a Hall current sensor (HS) configured to measure an electric current (I) flowing adjacent the active surface of the semiconductor die (14),
wherein the insulating encapsulation (20, 20', 20") has embedded therein an electrically conductive trace (100), the electrically conductive trace (100) having opposed ends providing therebetween a current flow path adjacent the active surface of the semiconductor die (14), with first (101) and second (181, 182, 120, 121) electrically conductive formations through the insulating encapsulation (20, 20', 20"), wherein:
the first (101) electrically conductive formations are coupled to the opposed ends of the electrically conductive trace (100) and are configured to cause (101) an electrical current subject to measurement to flow in said current flow path adjacent the active surface of the semiconductor die (14), and
the second electrically conductive formations (181, 182, 120, 121) are directed towards the active surface of the one semiconductor die (14) and are configured to activate the Hall current sensor (HS) integrated in the semiconductor die (14).

7. The method of claim 6 comprising:
laminating an insulating film (18), preferably an Ajinomoto Build-up Film, on the active surface of the semiconductor die (14),
opening vias (181') through the insulating film (18) laminated on the active surface of said semiconductor die (14), wherein the second electrically conductive formations (181, 182, 120, 121) towards the active surface of the semiconductor die (14) comprise electrically conductive material at the vias (181') opened through the insulating film (18).

8. The method of claim 6 or claim 7 wherein embedding in the insulating encapsulation (20, 20', 20") an electrically conductive trace (100) with first (101) and second (181, 182, 120, 121) electrically conductive formations through the insulating encapsulation (20, 20', 20"), is done either via photolithography or laser induced forward transfer, LIFT.

9. The method of any of the claims 6 to 8, wherein the semiconductor die (14) having a Hall current sensor (HS) integrated therein is a portion of a panel or wafer comprising a plurality of semiconductor dice (14) having a Hall current sensor (HS) integrated therein, the method comprising,
processing the semiconductor dice (14) according to any of the claims 6 to 8, and
singulating the panel or the wafer to obtain individual devices (10).

10. A method of using a device (10) according to any of claims 1 to 5, the method comprising:
applying an electrical current subject to measurement across the first electrically conductive formations (101), wherein the current subject to measurement flows in said current flow path adjacent the active surface of the semiconductor die (14), and
activating via the second electrically conductive formations (181, 182, 120, 121) the Hall current sensor (HS) integrated in the semiconductor die (14), wherein the Hall current sensor (HS) measures the electrical current flowing in said current flow path adjacent the active surface of the semiconductor die (14).
